# EUROPEAN PATENT APPLICATION

(11) **EP 2 747 128 A1**
(43) Date of publication of application: **25.06.2014**
(21) Application number: 12826064.3
(22) Date of filing: 09.07.2012
(51) Int. Cl.: H01L 21/266, H01L 21/265, H01L 21/336, H01L 29/12, H01L 29/78

(54) **METHOD FOR MANUFACTURING SILICON CARBIDE SEMICONDUCTOR DEVICE**

(30) Priority: 19.08.2011 JP 2011179278
(71) Applicant: Sumitomo Electric Industries, Ltd., Chuo-ku Osaka-shi Osaka 541-0041 (JP)
(72) Inventor: OOI, Naoki, Itami-shi Hyogo 664-0016 (JP)
(74) Representative: Grünecker, Kinkeldey, Stockmair & Schwanhäusser
(86) International application number: PCT/JP2012/067426
(87) International publication number: WO 2013/027502

(57) **Abstract**

A silicon carbide substrate (90) having a surface (SO) is prepared. A coating film (50) made of a first material is formed directly on the surface (SO) of the silicon carbide substrate (90). A mask layer (31) made of a second material is formed on the coating film (50). The first material is higher in adhesiveness with silicon carbide than the second material. A first opening (P1) is formed in the mask layer (31). First impurity ions for providing a first conductivity type are implanted into the silicon carbide substrate (90) by using ion beams (J1) passing through the first opening (P1) in the mask layer (31) and through the coating film (50).

## Description

### TECHNICAL FIELD

The present invention relates to a method for manufacturing a silicon carbide semiconductor device and particularly to a method having a step of implanting impurity ions.

### BACKGROUND ART

A semiconductor device (a silicon carbide semiconductor device) including a silicon carbide (SiC) substrate has recently been developed. In a method of manufacturing a semiconductor device, an impurity region should selectively be formed in a silicon carbide substrate. Therefore, a mask is formed for restricting a region into which ions are to be implanted, in implanting ions into the silicon carbide substrate. In addition, a film for adjusting a depth of implantation may be formed on the silicon carbide substrate.

For example, according to Japanese Patent Laying-Open No. 2009-177102 (PTL 1), an ion implantation mask composed of SiO₂ is formed on a surface of an SiC substrate. In addition, after the mask is formed and before ions are implanted, a film for adjusting a depth of ion implantation is formed.

### CITATION LIST

### PATENT LITERATURE

PTL 1: Japanese Patent Laying-Open No. 2009-177102

### SUMMARY OF INVENTION

### TECHNICAL PROBLEM

According to the method described in the literature above, a mask made of SiO₂ tends to disadvantageously peel off from the SiC substrate. In particular when the SiC substrate is heated, peel off has been likely and hence the SiC substrate provided with the mask could not sufficiently be heated. This fact imposes restriction on a method for manufacturing a silicon carbide semiconductor device. For example, an SiC substrate cannot be heated during ion implantation, and in this case, crystal defects attributed to ion implantation are likely in the SiC substrate.

The present invention was made in view of the problems above, and an object of the present invention is to provide a method for manufacturing a silicon carbide semiconductor device capable of implanting impurity ions into a silicon carbide substrate through a film for adjusting a depth of ion implantation and suppressing occurrence of peel off from the silicon carbide substrate.

### SOLUTION TO PROBLEM

A method for manufacturing a silicon carbide semiconductor device according to the present invention has the following steps. A silicon carbide substrate having a surface is prepared, A coating film made of a first material is formed directly on the surface of the silicon carbide substrate. A mask layer made of a second material is formed on the coating film. The first material is higher in adhesiveness with silicon carbide than the second material. A first opening is formed in the mask layer. First impurity ions for providing a first conductivity type are implanted into the silicon carbide substrate by using ion beams passing through the first opening in the mask layer and through the coating film.

According to the present invention, ion beams supplying first impurity ions into the silicon carbide substrate pass through the coating film before they reach the silicon carbide substrate. Thus, ions prevented at a relatively shallow position from advancing are implanted into the coating film, and ions prevented at a relatively deep position from advancing are implanted into the silicon carbide substrate. Therefore, a shallow position in an implantation profile is a position occupied by the coating film, rather than a position occupied by the silicon carbide substrate. Therefore, the implantation profile the shallow region of which is excluded can be an impurity concentration profile of the silicon carbide substrate.

In addition, according to the present invention, it is the coating film rather than a mask layer, that is directly formed on the silicon carbide substrate. Therefore, a material formed directly on the silicon carbide substrate can be a first material which is a material for the coating film higher in adhesiveness with silicon carbide than the second material, rather than the second material which is a material for the mask layer. Thus, occurrence of peel off from the silicon carbide substrate can be suppressed.

In the method for manufacturing a silicon carbide semiconductor device above, in the step of implanting first impurity ions, the silicon carbide substrate may be heated.

Since the coating film formed on the silicon carbide substrate is high in adhesiveness with silicon carbide, it is less likely to peel off even though the silicon carbide substrate is heated. In addition, by heating this silicon carbide substrate, occurrence of crystal defects caused at the time of ion implantation can be suppressed.

In the method for manufacturing a silicon carbide semiconductor device above, the step of implanting first impurity ions may be performed under such a condition that an implantation profile of the first impurity ions in a direction of thickness is flat at the surface of the silicon carbide substrate.

Thus, a concentration profile of the first impurity ions from the surface of the silicon carbide substrate to a portion in the vicinity thereof can be flat.

In the method for manufacturing a silicon carbide semiconductor device above, after the step of forming a coating film and before the step of implanting first impurity ions, a first blocking film made of a material higher in capability of blocking the ion beams than the first material may be formed on the coating film.

Thus, a concentration profile of the first impurity ions in the silicon carbide substrate can be a portion of the implantation profile of ion implantation, excluding by a wider range a shallow position where concentration abruptly increases.

In the method for manufacturing a silicon carbide semiconductor device above, the step of forming a first blocking film may be performed after the step of forming a first opening.

Thus, partial removal of even the first blocking film involved with a process for forming a first opening is unlikely. Therefore, a film thickness of the first blocking film during ion implantation can be stabilized.

In the method for manufacturing a silicon carbide semiconductor device above, the step of forming a first blocking film may be performed before the step of forming a mask layer. After the step of forming a first blocking film and before the step of forming a mask layer, an etching stop layer made of a material different from the second material may be formed.

Thus, the etching stop layer can be used for stopping etching for forming the first opening in the mask layer.

In the method for manufacturing a silicon carbide semiconductor device above, in the step of forming a first opening, the first opening having a first bottom surface and a first sidewall is formed in the mask layer. A mask portion having the mask layer and a spacer layer may be formed by forming the spacer layer on the first bottom surface and the first sidewall after the step of implanting first impurity ions. A second opening having a second bottom surface and a second sidewall may be formed in the mask portion by removing the spacer layer on the first bottom surface and allowing the spacer layer on the first sidewall to remain by anisotropically etching the spacer layer in the first opening. Second impurity ions for providing a second conductivity type different from the first conductivity type may be implanted into the silicon carbide substrate by using ion beams passing through the second opening.

Thus, a region into which a second impurity is implanted can be formed in a manner self-aligned with a region into which first impurity ions are implanted.

In the method for manufacturing a silicon carbide semiconductor device above, after the step of forming a second opening and before the step of implanting second impurity ions, a second blocking film may be formed on the second bottom surface of the second opening.

Thus, a concentration profile of the second impurity ions in the silicon carbide substrate can be a portion of the implantation profile of ion implantation, excluding by a wider range a shallow position where concentration abruptly increases.

In the method for manufacturing a silicon carbide semiconductor device above, the second material may be silicon oxide. The first material may be any of titanium, polysilicon, and silicon nitride.

### ADVANTAGEOUS EFFECTS OF INVENTION

As is clear from the description above, according to the present invention, impurity ions can be implanted into a silicon carbide substrate through a film for adjusting a depth of ion implantation and occurrence of peel off from the silicon carbide substrate can be suppressed.

### BRIEF DESCRIPTION OF DRAWINGS

Fig. 1 is a partial cross-sectional view schematically showing a construction of a silicon carbide semiconductor device in a first embodiment of the present invention.
Fig. 2 is a partial cross-sectional view schematically showing a first step in a method for manufacturing a silicon carbide semiconductor device in Fig. 1.
Fig. 3 is a partial cross-sectional view schematically showing a second step in the method for manufacturing a silicon carbide semiconductor device in Fig. 1.
Fig. 4 is a partial cross-sectional view schematically showing a third step in the method for manufacturing a silicon carbide semiconductor device in Fig. 1.
Fig. 5 is a partial cross-sectional view schematically showing a fourth step in the method for manufacturing a silicon carbide semiconductor device in Fig. 1.
Fig. 6 is a partial cross-sectional view schematically showing a fifth step in the method for manufacturing a silicon carbide semiconductor device in Fig. 1.
Fig. 7 is a partial cross-sectional view schematically showing a sixth step in the method for manufacturing a silicon carbide semiconductor device in Fig. 1.
Fig. 8 is a partial cross-sectional view schematically showing a seventh step in the method for manufacturing a silicon carbide semiconductor device in Fig. 1.
Fig. 9 is a partial cross-sectional view schematically showing an eighth step in the method for manufacturing a silicon carbide semiconductor device in Fig. 1.
Fig. 10 is a partial cross-sectional view schematically showing a ninth step in the method for manufacturing a silicon carbide semiconductor device in Fig. 1.
Fig. 11 is a partial cross-sectional view schematically showing a tenth step in the method for manufacturing a silicon carbide semiconductor device in Fig. 1.
Fig. 12 is a partial cross-sectional view schematically showing an eleventh step in the method for manufacturing a silicon carbide semiconductor device in Fig. 1.
Fig. 13 is a partial cross-sectional view schematically showing a twelfth step in the method for manufacturing a silicon carbide semiconductor device in Fig. 1.
Fig. 14 is a partial cross-sectional view schematically showing a thirteenth step in the method for manufacturing a silicon carbide semiconductor device in Fig. 1.
Fig. 15 is a partial cross-sectional view schematically showing a fourteenth step in the method for manufacturing a silicon carbide semiconductor device in Fig. 1.
Fig. 16 is a partial cross-sectional view schematically showing a fifteenth step in the method for manufacturing a silicon carbide semiconductor device in Fig. 1.
Fig. 17 is a partial cross-sectional view schematically showing a sixteenth step in the method for manufacturing a silicon carbide semiconductor device in Fig. 1.
Fig. 18 is a partial cross-sectional view schematically showing a seventeenth step in the method for manufacturing a silicon carbide semiconductor device in Fig. 1.
Fig. 19 is a partial cross-sectional view schematically showing an eighteenth step in the method for manufacturing a silicon carbide semiconductor device in Fig. 1.
Fig. 20 is a graph showing one example of an implantation profile formed in the step in Fig. 8.
Fig. 21 is a partial cross-sectional view schematically showing one step in a method for manufacturing a silicon carbide semiconductor device in a second embodiment of the present invention.
Fig. 22 is a partial cross-sectional view schematically showing one step in a method for manufacturing a silicon carbide semiconductor device in a third embodiment of the present invention.
Fig. 23 is a partial cross-sectional view schematically showing one step in a method for manufacturing a silicon carbide semiconductor device in a fourth embodiment of the present invention.
Fig. 24 is a partial cross-sectional view schematically showing one step in a method for manufacturing a silicon carbide semiconductor device in a fifth embodiment of the present invention.
Fig. 25 is a partial cross-sectional view schematically showing one step in a method for manufacturing a silicon carbide semiconductor device in a sixth embodiment of the present invention.

### DESCRIPTION OF EMBODIMENTS

An embodiment of the present invention will be described hereinafter with reference to the drawings.

### (First Embodiment)

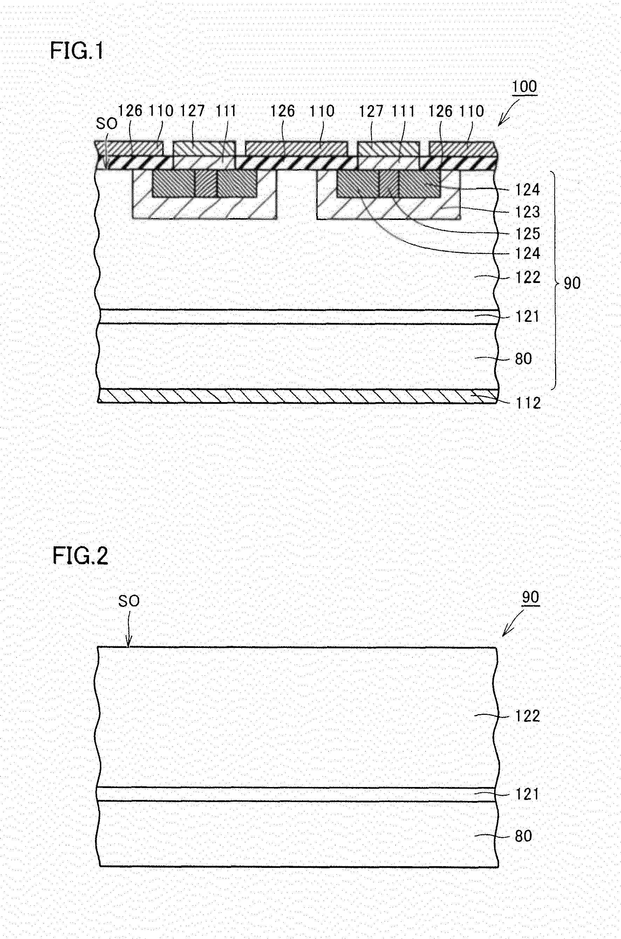

As shown in Fig. 1, a silicon carbide semiconductor device in the present embodiment is a MOSFET 100, and it is specifically a vertical DiMOSFET (Double Implanted MOSFET). MOSFET 100 has an epitaxial substrate 90, an oxide film 126, a source electrode 111, an upper source electrode 127, a gate electrode 110, and a drain electrode 112. Epitaxial substrate 90 has a single crystal substrate 80, a buffer layer 121, a breakdown voltage holding layer 122, a p region 123, an n⁺ region 124, and ap⁺ region 125. A two-dimensional shape (a shape when viewed from above in Fig. 1) of MOSFET 100 is for example, a rectangle or a square having a side of a length not shorter than 2 mm.

Single crystal substrate 80 and buffer layer 121 each have an n conductivity type. Single crystal substrate 80 is preferably composed of silicon carbide. Concentration of an n-type conductive impurity in buffer layer 121 is, for example, 5×10¹⁷ cm⁻³. In addition, buffer layer 121 has a thickness, for example, of 0.5 µm.

Breakdown voltage holding layer 122 is formed on buffer layer 121, and it is composed of silicon carbide having the n conductivity type. For example, breakdown voltage holding layer 122 has a thickness of 10 µm and concentration of an n-type conductive impurity is 5×10¹⁵ cm⁻³.

In a surface SO of epitaxial substrate 90, a plurality of p regions 123 having a p conductivity type are formed at a distance from one another. In addition, in surface SO, n⁺ region 124 is formed to be located inside each p region 123. Moreover, p⁺ region 125 is formed to penetrate n⁺ region 124 from surface SO to p region 123. In surface SO, p region 123 has a channel region lying between n⁺ region 124 and breakdown voltage holding layer 122 and covered with gate electrode 110 with oxide film 126 being interposed. The channel region has a channel length CL.

On breakdown voltage holding layer 122 exposed between the plurality of p regions 123 at surface SO, oxide film 126 is formed. Specifically, oxide film 126 is formed to extend from n⁺ region 124 in one p region 123 to p region 123, breakdown voltage holding layer 122 exposed between two p regions 123, the other p region 123, and n⁺ region 124 in the other p region 123. Gate electrode 110 is formed on oxide film 126. Therefore, a portion of oxide film 126 having gate electrode 110 formed thereon has a function as a gate insulating film. In addition, source electrode 111 is formed on n⁺ region 124 and p⁺ region 125. Upper source electrode 127 is formed on source electrode 111.

A method for manufacturing MOSFET 100 will now be described.

As shown in Fig. 2, epitaxial substrate 90 (silicon carbide substrate) having surface SO is prepared. Specifically, buffer layer 121 is formed on a main surface of single crystal substrate 80, and breakdown voltage holding layer 122 is formed on buffer layer 121. Buffer layer 121 is composed of silicon carbide having the n conductivity type, and it has a thickness, for example, of 0.5 µm. In addition, concentration of the conductive impurity in buffer layer 121 is set, for example, to 5×10¹⁷ cm⁻³. Breakdown voltage holding layer 122 has a thickness, for example, of 10 µm. Further, concentration of the n conductive impurity in breakdown voltage holding layer 122 is set, for example, to 5×10¹⁵ cm⁻³.

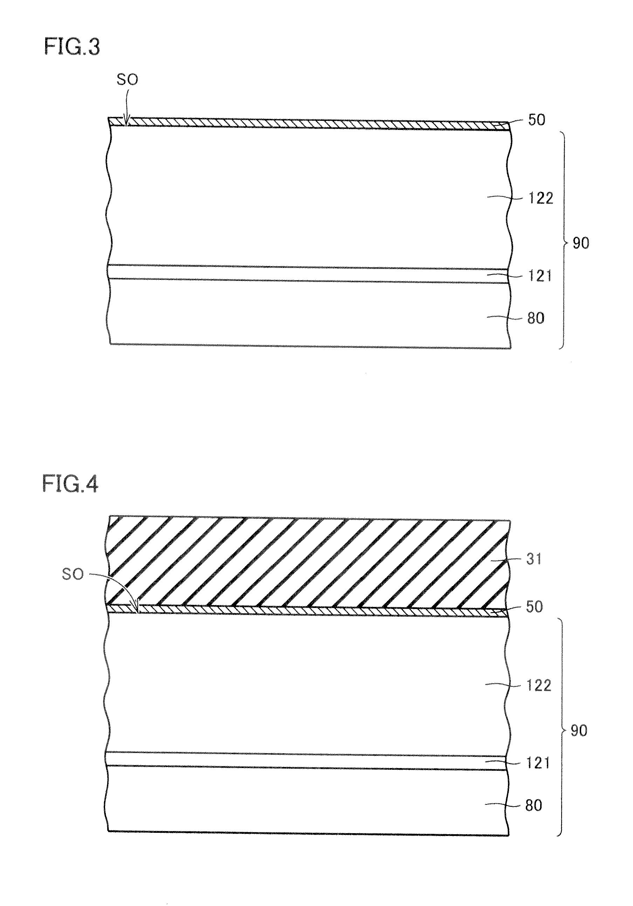

As shown in Fig. 3, a coating film 50 is formed directly on surface SO of epitaxial substrate 90. As a material for coating film 50 (a first material), a material higher in adhesiveness with silicon carbide than a material for a mask layer 31 (Fig. 4) (a second material) which will be described later is selected. A degree of adhesiveness between a certain material and silicon carbide can be determined, for example, by forming a film made of this material on the silicon carbide substrate and checking a degree of adhesiveness between this film and the silicon carbide substrate. This test for adhesiveness is preferably conducted after the silicon carbide substrate on which this film has been formed is subjected to heat treatment. A temperature for heat treatment is preferably set in correspondence with a highest temperature at which epitaxial substrate 90 provided with mask layer 31 and coating film 50 is placed, and for example, determination as to acceptable adhesiveness is made based on whether a film peels off at 500°C which is a heating temperature during ion implantation.

Preferably, a material for coating film 50 (a first material) is any of titanium, polysilicon, and silicon nitride. These materials are higher in adhesiveness with silicon carbide than silicon oxide. For example, in a case of using titanium, a thickness thereof is, for example, from 80 to 300 nm. In addition, sputtering can be employed as a method of forming the coating film. In a case where metal contamination of epitaxial substrate 90 should be avoided as much as possible, a material for coating film 50 is preferably a non-metal, and for example, polysilicon or silicon nitride can be employed.

As shown in Fig. 4, mask layer 31 is formed on coating film 50. Preferably, a material for mask layer 31 (a second material) is silicon oxide. For example, a p-CVD (plasma-Chemical Vapor Deposition) method is employed as a method of forming mask layer 31. Mask layer 31 has a thickness, for example, from 0.1 to 2.5 µm.

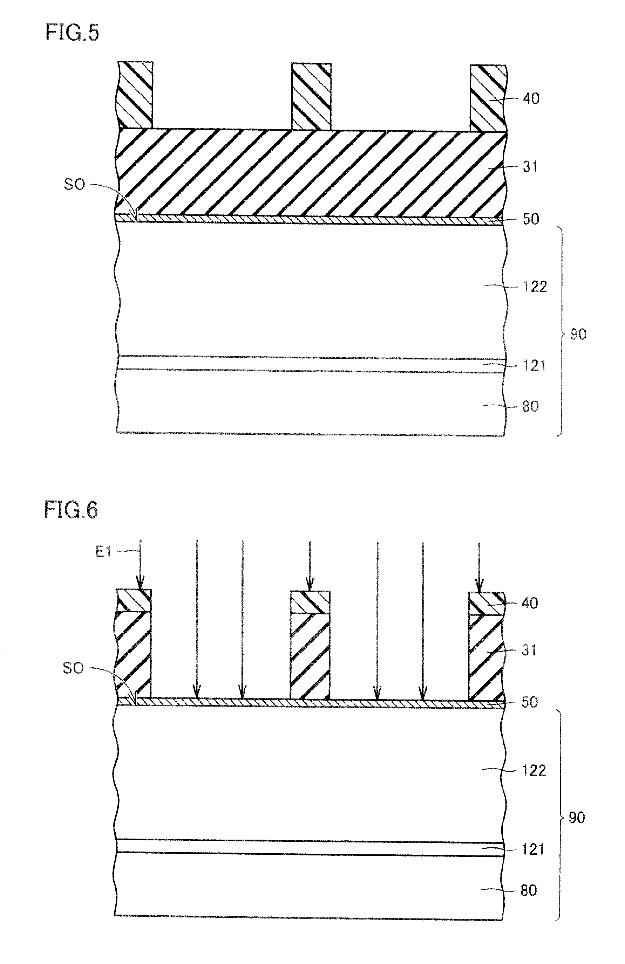

As shown in Fig. 5, a photoresist pattern 40 is formed on mask layer 31. This formation can be achieved with photolithography.

As shown in Fig. 6, mask layer 31 is patterned through anisotropic etching E1 using photoresist pattern 40 as a mask. Anisotropic etching can be achieved, for example, by RIE (Reactive Ion Etching) mainly using a process gas containing CHF₃ and CF₄. Thereafter, remaining photoresist pattern 40 is removed.

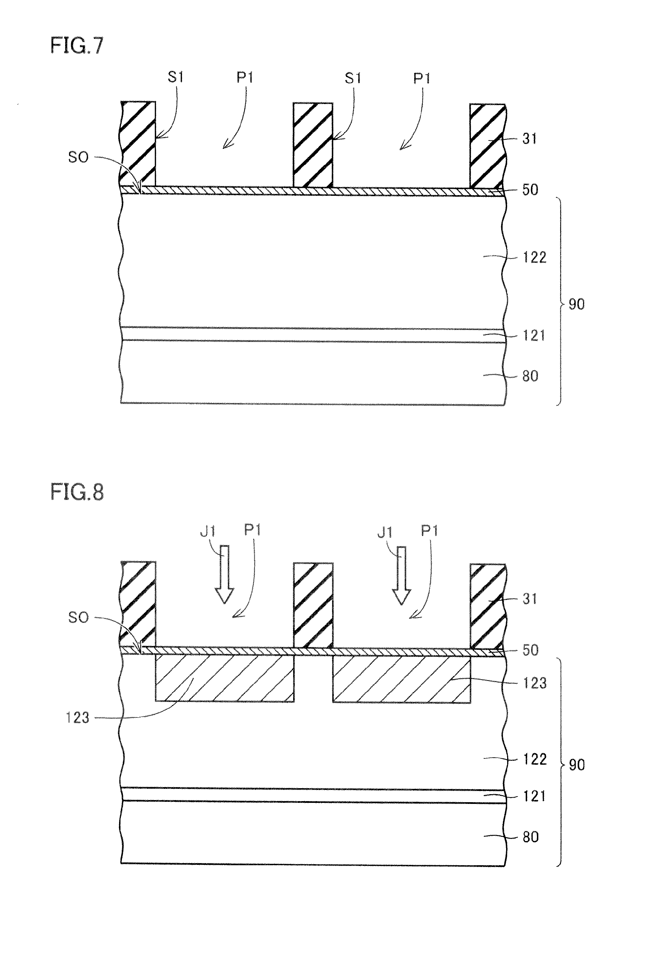

As shown in Fig. 7, as a result of etching above, an opening P1 (a first opening) having a sidewall S 1 (a first sidewall) and a bottom surface surrounded thereby (a first bottom surface) is formed in mask layer 31.

As shown in Fig. 8, first impurity ions for providing a p-type (a first conductivity type) are implanted into epitaxial substrate 90 by using ion beams J1 passing through opening P1 in mask layer 31 and through coating film 50. First impurity ions are, for example, aluminum (A1) ions or boron (B) ions. As a result of this ion implantation, p region 123 having the p-type is formed from surface SO to a prescribed depth in epitaxial substrate 90. This ion implantation may be achieved by what is called multi-step implantation. Namely, a plurality of times of ion implantation different in implanted energy may be carried out.

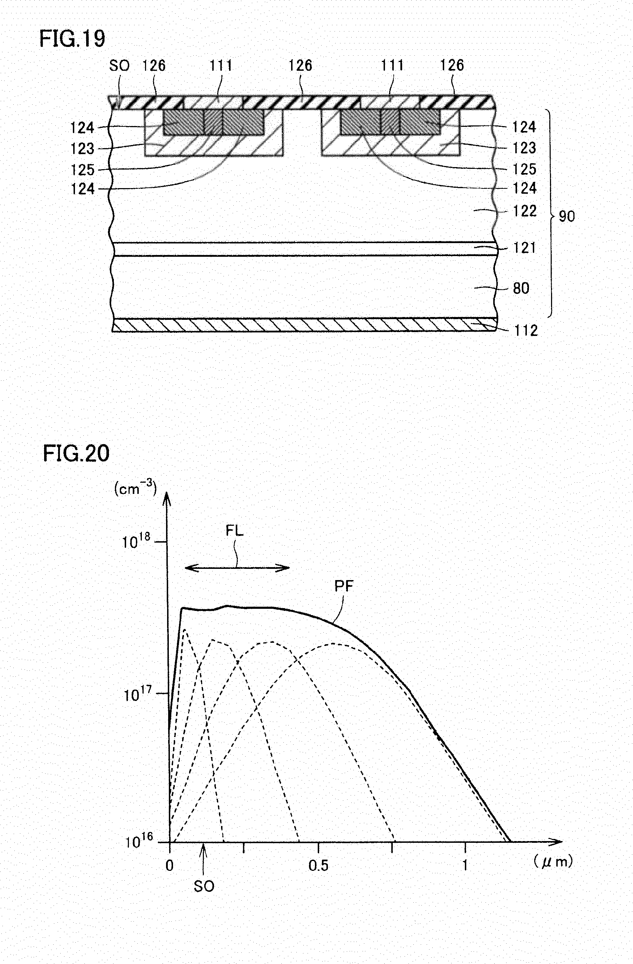

Fig. 20 shows an example of multi-step implantation, and in this example, an implantation profile PF is formed through 4 times of implantation (each implantation shown with a dashed line in the figure) different in implanted energy. In a shallowest portion of implantation profile PF (a portion from the origin on the abscissa to a portion in the vicinity thereof), abrupt increase in impurity concentration is observed and a position of this portion is occupied by coating film 50. At an intermediate depth, as a result of multi-step implantation, a flat region FL is formed in implantation profile PF. Concentration profile "being flat" herein can be defined as variation in impurity concentration in a range not less than 0.05 µm in a direction of depth being within ±50%. Impurity implantation in this example has such a process condition as forming a flat concentration profile from surface SO of epitaxial substrate 90. In other words, ion implantation is carried out under such a condition that implantation profile PF is flat at surface SO.

Preferably, during ion implantation, the epitaxial substrate is heated. In order to sufficiently suppress occurrence of crystal defects in epitaxial substrate 90, a heating temperature is preferably not lower than 400°C. In addition, in order to avoid an extremely complicated construction of an ion implantation apparatus having a heating mechanism, a heating temperature is preferably not higher than 600°C. Specifically, a heating temperature is around 500°C.

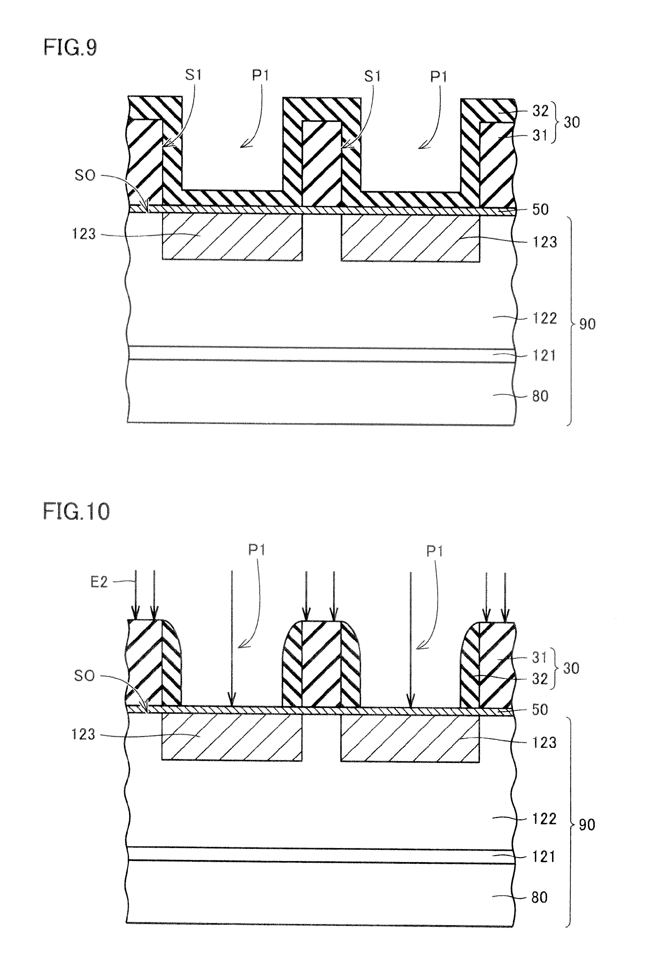

As shown in Fig. 9, thereafter by deposition on coating film 50 on which mask layer 31 has been provided, a spacer layer 32 is formed on sidewall S 1 and the bottom surface of opening P1. In other words, a mask portion 30 having mask layer 31 and spacer layer 32 is formed. Spacer layer 32 covers sidewall S1 and coating film 50 in opening P1. Preferably, spacer layer 32 is made of silicon oxide. Preferably, epitaxial substrate 90 is heated when spacer layer 32 is formed. This heating temperature is set, for example, approximately to 300 to 400°C.

As shown in Fig. 10, spacer layer 32 in opening P1 is etched by anisotropic etching E2. Thus, spacer layer 32 on the bottom surface of opening P1 is removed and spacer layer 32 on sidewall S1 is allowed to remain. Anisotropic etching E2 can be performed with a method the same as anisotropic etching E1 (Fig. 6).

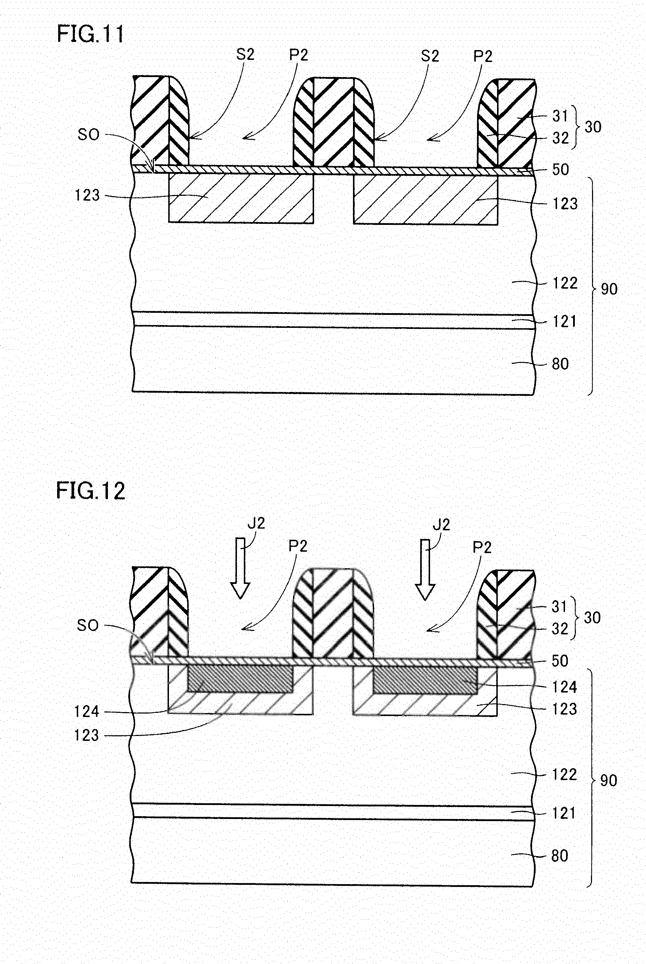

As shown in Fig. 11, in the step above, an opening P2 (a second opening) having a sidewall S2 (a second sidewall) and a bottom surface surrounded thereby (a second bottom surface) is formed in mask portion 30.

As shown in Fig. 12, second impurity ions for providing an n-type (a second conductivity type different from the first conductivity type) are implanted into epitaxial substrate 90 by using ion beams J2 passing through opening P2. Second impurity ions are, for example, phosphorus (P) ions. As a result of this ion implantation, n⁺ region 124 is formed from surface SO to a prescribed depth in epitaxial substrate 90. Preferably, as in ion implantation (Fig. 8) by using ion beams J1, epitaxial substrate 90 is heated.

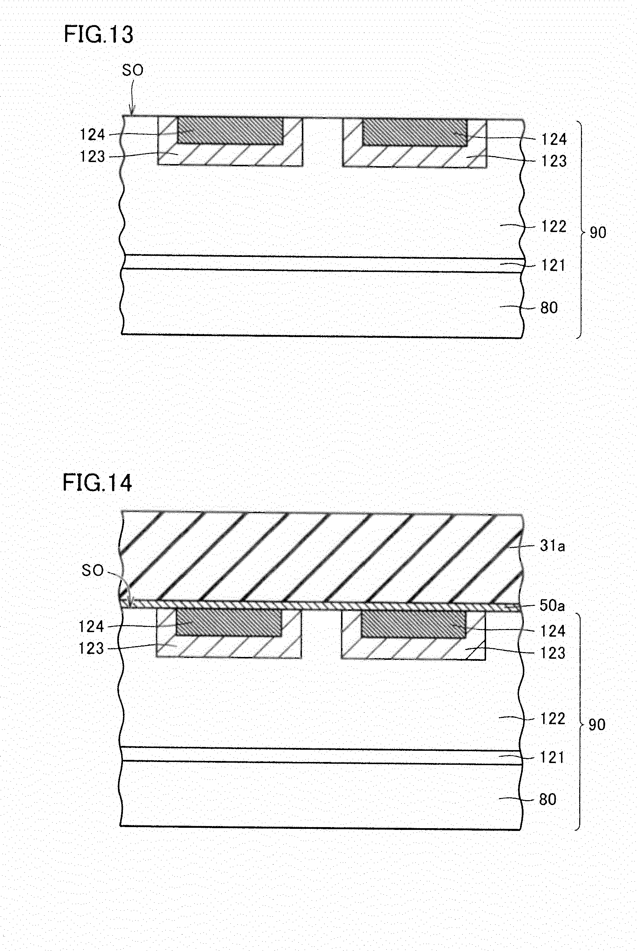

As shown further in Fig. 13, thereafter, mask portion 30 and coating film 50 are removed. This removal can be achieved, for example, by wet etching.

As shown in Fig. 14, a coating film 50a is formed on surface SO. Coating film 50a can be formed similarly to coating film 50 described above. Then, a mask layer 31 a is formed on coating film 50a. Mask layer 31 a can be formed similarly to mask layer 31 described above.

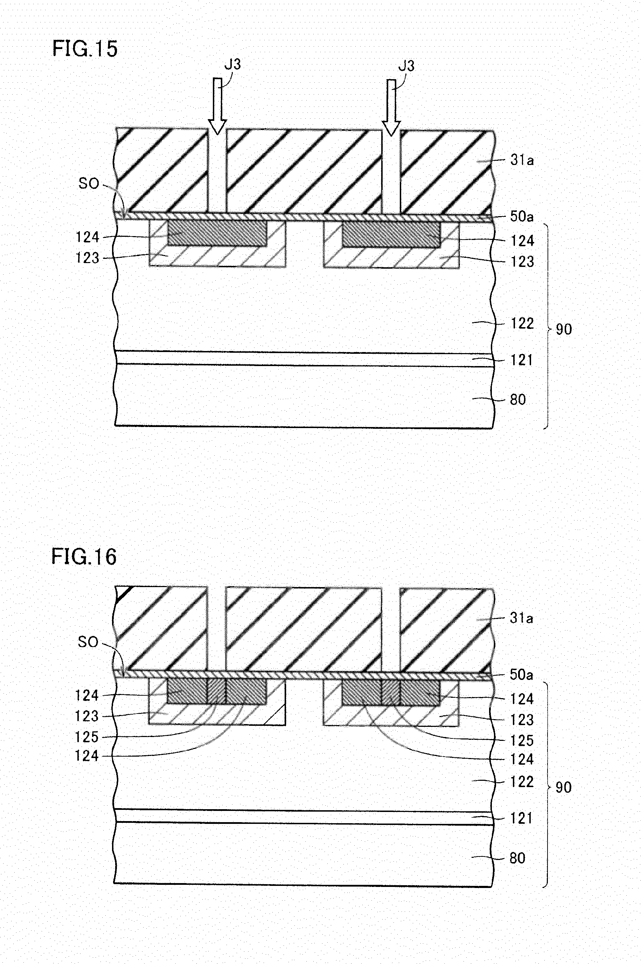

As shown in Fig. 15, an opening is formed in mask layer 31 a. Third impurity ions for providing the p-type (the first conductivity type) are implanted into epitaxial substrate 90 by using ion beams J3 passing through this opening. The third impurity ions are, for example, aluminum (Al) ions. Preferably, as in ion implantation (Fig. 8) by using ion beams J1, epitaxial substrate 90 is heated.

As shown in Fig. 16, p⁺ region 125 is formed in epitaxial substrate 90 through ion implantation above.

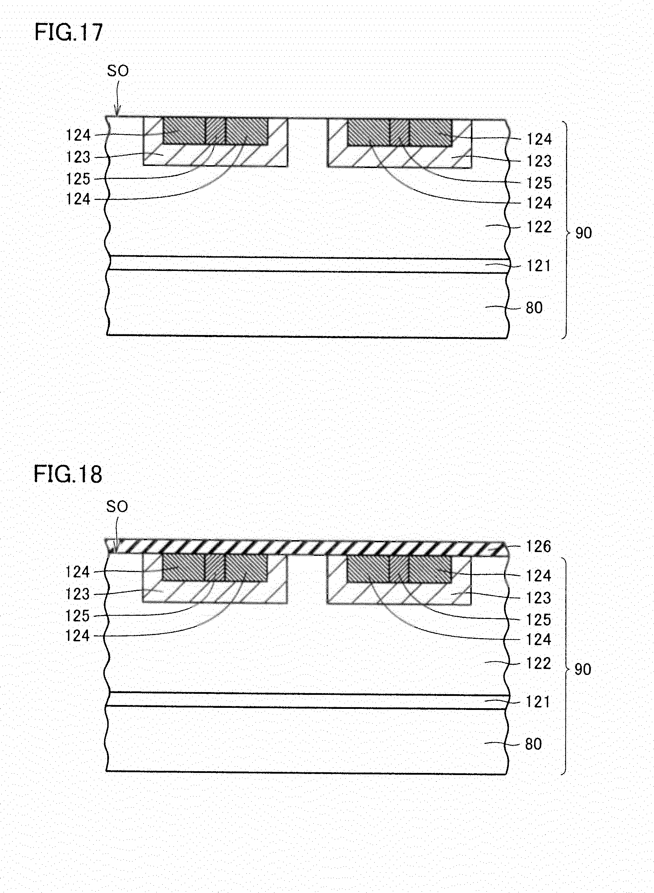

As shown in Fig. 17, thereafter, mask layer 31 a and coating film 50a are removed. In addition, activation annealing treatment is performed. For example, annealing for 30 minutes at a heating temperature of 1700°C in an argon atmosphere is performed.

As shown in Fig. 18, oxide film 126 which will have a function as a gate insulating film is formed on epitaxial substrate 90. Specifically, oxide film 126 is formed to cover breakdown voltage holding layer 122, p region 123, and n⁺ region 124. This formation may be carried out by dry oxidation (thermal oxidation). Conditions in dry oxidation are, for example, a heating temperature of 1200°C and a heating time period of 30 minutes.

Thereafter, a nitriding annealing step is performed. Specifically, annealing treatment in a nitrogen monoxide (NO) atmosphere is performed. Conditions in this treatment are, for example, a heating temperature of 1100°C and a heating time period of 120 minutes. Consequently, nitrogen atoms are introduced in the vicinity of an interface between each of breakdown voltage holding layer 122, p region 123 and n⁺ region 124 and oxide film 126. It is noted that, after this annealing step using nitrogen monoxide, annealing treatment using an argon (Ar) gas which is an inert gas may further be performed. Conditions in this treatment are, for example, a heating temperature of 1100°C and a heating time period of 60 minutes.

As shown in Fig. 19, source electrode 111 is formed as follows.

A resist film having a pattern is formed on oxide film 126 with photolithography. Using this resist film as a mask, a portion of oxide film 126 located on n⁺ region 124 and p⁺ region 125 is etched away. Thus, an opening is formed in oxide film 126. Then, a conductor film is formed in this opening to be in contact with n⁺ region 124 and p⁺ region 125. Then, by removing the resist film, a portion of the conductor film above that has been located on the resist film is removed (lift-off). This conductor film may be a metal film and it is composed, for example, of nickel (Ni). As a result of this lift-off, source electrode 111 is formed.

It is noted that heat treatment for alloying is preferably performed here. For example, heat treatment for 2 minutes at a heating temperature of 950°C in an atmosphere of an argon (Ar) gas which is an inert gas is performed.

Referring again to Fig. 1, upper source electrode 127 is formed on source electrode 111. In addition, gate electrode 110 is formed on oxide film 126. Moreover, drain electrode 112 is formed on a back surface (a lower surface in the drawing) of single crystal substrate 80.

MOSFET 100 (Fig. 1) is obtained as above.

According to the present embodiment, ion beams J1 (Fig. 8) pass through coating film 50 before they reach epitaxial substrate 90. Namely, an object into which ions are to be implanted includes coating film 50 and epitaxial substrate 90, and ions prevented at a relatively shallow position from advancing are implanted into coating film 50, and ions prevented at a relatively deep position from advancing are implanted into epitaxial substrate 90. Therefore, a shallow position in implantation profile PF (Fig. 20) formed in an object into which ions are to be implanted is a position occupied by coating film 50, rather than a position occupied by epitaxial substrate 90. Thus, the implantation profile the shallow region of which is excluded can be an impurity concentration profile of epitaxial substrate 90.

In addition, according to the present embodiment, a material formed directly on epitaxial substrate 90 can be a material for coating film 50, rather than a material for mask layer 31. Then, this material for coating film 50 can be a material higher in adhesiveness with silicon carbide than a material for mask layer 31. Thus, occurrence of peel off from epitaxial substrate 90 can be suppressed.

Moreover, during ion implantation, epitaxial substrate 90 as a silicon carbide substrate is heated. Since coating film 50 formed on epitaxial substrate 90 has high adhesiveness with silicon carbide, it is less likely to peel off even though epitaxial substrate 90 made of silicon carbide is heated. Therefore, occurrence of peel off from epitaxial substrate 90 can be suppressed. Then, by heating this epitaxial substrate 90, occurrence of crystal defects caused at the time of ion implantation can be suppressed.

Furthermore, ion implantation by using ion beams J1 (Fig. 8) is carried out under such a condition that implantation profile PF (Fig. 20) becomes flat region FL from surface SO of epitaxial substrate 90 to a portion in the vicinity thereof. Thus, a concentration profile from surface SO of epitaxial substrate 90 to the portion in the vicinity thereof can be flat.

When mask layer 31 is patterned through anisotropic etching E1 (Fig. 6), coating film 50 made of a material different from that for mask layer 31 can be used as an etching stopper.

After ion implantation by using ion beams J 1 passing through opening P1, spacer layer 32 is formed on sidewall S 1 of opening P1, so that mask portion 30 (Fig. 12) for ion implantation by using ion beams J2 is formed. Thus, a region formed through ion implantation by using ion beams J2 can be formed in a manner self-aligned with a region formed by using ion beams J1.

Even in a case where epitaxial substrate 90 is heated in forming spacer layer 32, coating film 50 formed on epitaxial substrate 90 has high adhesiveness with silicon carbide and hence it is less likely to peel off. Therefore, occurrence of peel off from epitaxial substrate 90 can be suppressed.

### (Second Embodiment)

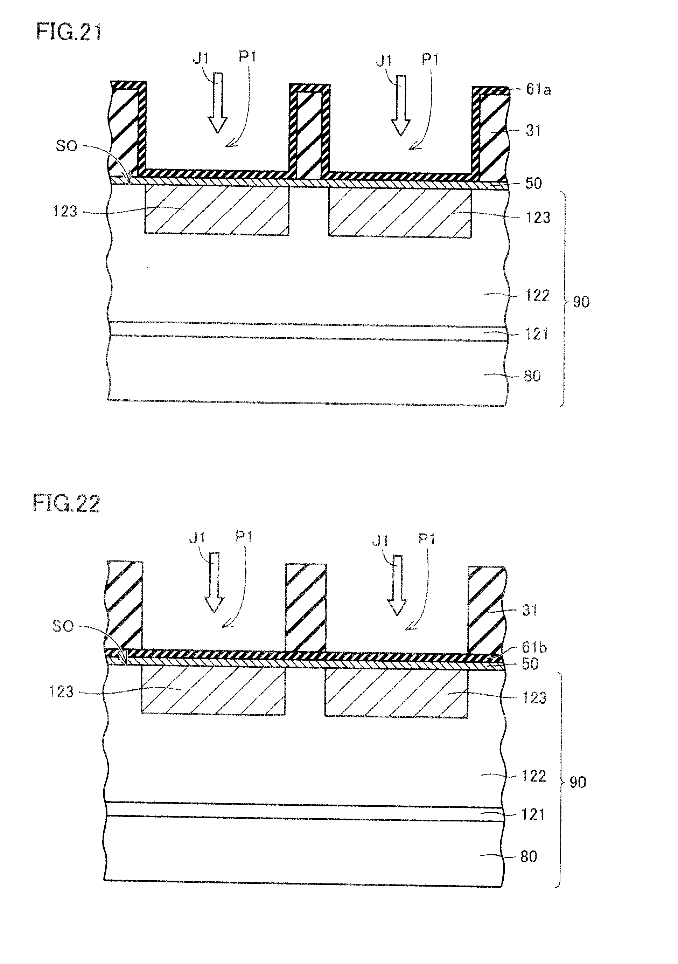

As shown in Fig. 21, in the present embodiment, after coating film 50 is formed and before ion implantation by using ion beams J1 is carried out, a blocking film 61a (a first blocking film) made of a material higher in capability of blocking ion beams than the material for coating film 50 is formed. In particular, in the present embodiment, blocking film 61 a is formed after opening P1 is formed. A material for blocking film 61 a may be the same as the material for mask layer 31, and it is, for example, silicon oxide.

Since the construction other than the above is substantially the same as in the first embodiment described above, the same or corresponding elements have the same reference characters allotted and description thereof will not be repeated.

According to the present embodiment, after ion beams J1 (Fig. 21) pass through not only coating film 50 but also blocking film 61a, they reach epitaxial substrate 90. Thus, a shallow position in implantation profile PF (Fig. 20) (a portion close to the origin on the abscissa) is occupied by a portion other than epitaxial substrate 90 across a wider range. Therefore, a concentration profile formed from surface SO of epitaxial substrate 90 to a portion in the vicinity thereof can be a portion of implantation profile PF, excluding by a wider range a portion at a shallow position. More specifically, a concentration profile formed from the surface of epitaxial substrate 90 to the portion in the vicinity thereof can be flatter.

In addition, blocking film 61a is formed after opening P1 is formed. Thus, partial removal of even blocking film 61 a involved with a process for forming opening P1 is unlikely. Therefore, a film thickness of blocking film 61a during ion implantation can be stabilized.

### (Third Embodiment)

As shown in Fig. 22, in the present embodiment, a blocking film 61b (a first blocking film) is formed before mask layer 31 is formed.

Since the construction other than the above is substantially the same as in the second embodiment described above, the same or corresponding elements have the same reference characters allotted and description thereof will not be repeated.

According to the present embodiment, after ion beams J1 (Fig. 22) pass through not only coating film 50 but also blocking film 61 b, they reach epitaxial substrate 90. Thus, a shallow position in implantation profile PF (Fig. 20) (a portion close to the origin on the abscissa) is occupied by a portion other than epitaxial substrate 90 across a wider range. Therefore, a concentration profile formed from surface SO of epitaxial substrate 90 to a portion in the vicinity thereof can be a portion of implantation profile PF, excluding by a wider range a portion at a shallow position. More specifically, a concentration profile formed from the surface of epitaxial substrate 90 to the portion in the vicinity thereof can be flatter.

### (Fourth Embodiment)

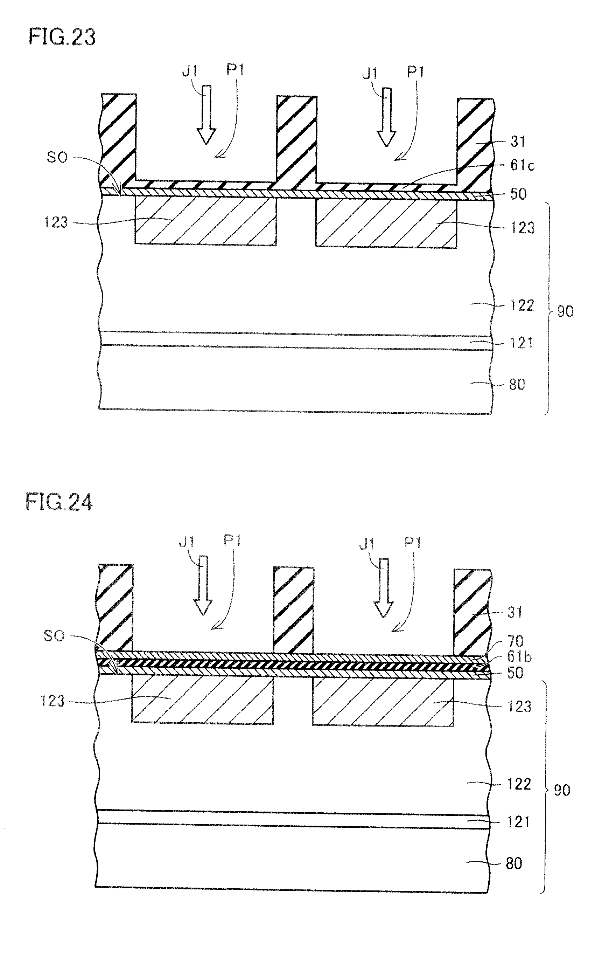

As shown in Fig. 23, in the present embodiment, etching for patterning mask layer 31 is stopped at a position intermediate in a direction of thickness so that a blocking film 61c (a first blocking film) is formed on the bottom surface of opening P1.

Since the construction other than the above is substantially the same as in the second embodiment described above, the same or corresponding elements have the same reference characters allotted and description thereof will not be repeated.

According to the present embodiment, after ion beams J1 (Fig. 23) pass through not only coating film 50 but also blocking film 61c, they reach epitaxial substrate 90. Thus, a shallow position in implantation profile PF (Fig. 20) (a portion close to the origin on the abscissa) is occupied by a portion other than epitaxial substrate 90 across a wider range. Therefore, a concentration profile formed from surface SO of epitaxial substrate 90 to a portion in the vicinity thereof can be a portion of implantation profile PF, excluding by a wider range a portion at a shallow position. More specifically, a concentration profile formed from the surface of epitaxial substrate 90 to the portion in the vicinity thereof can be flatter.

### (Fifth Embodiment)

As shown in Fig. 24, in the present embodiment, after blocking film 61b is formed and before mask layer 31 is formed, an etching stop layer 70 made of a material different from the material for mask layer 31 is formed. Thus, etching stop layer 70 can be used for stopping etching for forming opening P1 in mask layer 31.

Since the construction other than the above is substantially the same as in the third embodiment described above, the same or corresponding elements have the same reference characters allotted and description thereof will not be repeated.

According to the present embodiment, regardless of a material for blocking film 61b, etching stop layer 70 is used during etching of mask layer 31, so that mask layer 31 can accurately be patterned. Therefore, a material for blocking film 61 b may be the same as the material for mask layer 31.

### (Sixth Embodiment)

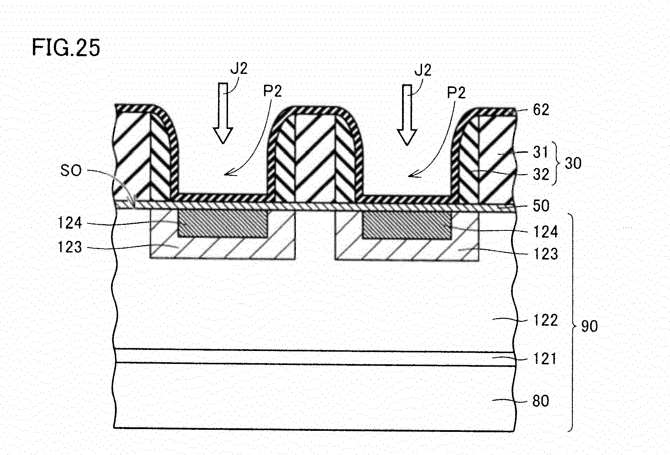

As shown in Fig. 25, in the present embodiment, after opening P2 is formed and before ion implantation by using ion beams J2 is carried out, a blocking film 62 (a second blocking film) is formed on a bottom surface of opening P2. Specifically, silicon oxide is deposited after opening P2 is formed so that blocking film 62 can be formed.

Since the construction other than the above is substantially the same as in the first embodiment described above, the same or corresponding elements have the same reference characters allotted and description thereof will not be repeated.

According to the present embodiment, after ion beams J2 (Fig. 25) pass through not only coating film 50 but also blocking film 62, they reach epitaxial substrate 90. Thus, a shallow position in the implantation profile is occupied by a portion other than epitaxial substrate 90 across a wider range. Therefore, a concentration profile formed from surface SO of epitaxial substrate 90 to a portion in the vicinity thereof can be a portion of the implantation profile, excluding by a wider range a portion at a shallow position. More specifically, a concentration profile formed from the surface of epitaxial substrate 90 to the portion in the vicinity thereof can be flatter.

In addition, blocking film 62 is formed after opening P2 is formed. In other words, when opening P2 is formed, blocking film 62 has not yet been formed. Therefore, presence of blocking film 62 at the time of formation of opening P2 does not give rise to a problem.

Though a case where a flat concentration profile is formed from surface SO of epitaxial substrate 90 (Fig. 20) has been described in each embodiment above, a concentration profile formed from surface SO is not limited to a flat concentration profile and it may be a desired profile in accordance with design of a semiconductor device.

In each embodiment above, p-type and n-type may be interchanged. In addition, in each embodiment above, though epitaxial substrate 90 is employed as the silicon carbide substrate, a silicon carbide single crystal substrate may be employed instead.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

### REFERENCE SIGNS LIST

30 mask portion; 31 mask layer; 32 spacer layer; 50 coating film; 61a to 61c blocking film (first blocking film); 62 blocking film (second blocking film); 70 etching stop layer; 80 single crystal substrate; 90 epitaxial substrate (silicon carbide substrate); 123 p region; 124 n⁺ region; 125 p⁺ region; P1 opening (first opening); P2 opening (second opening); SO surface; S 1 sidewall (first sidewall); and S2 sidewall (second sidewall).

## Claims

1. A method for manufacturing a silicon carbide semiconductor device, comprising the steps of:
preparing a silicon carbide substrate (90) having a surface (SO);
forming a coating film (50) made of a first material directly on said surface of said silicon carbide substrate;
forming a mask layer (31) made of a second material on said coating film, said first material being higher in adhesiveness with silicon carbide than said second material;
forming a first opening (P1) in said mask layer; and
implanting first impurity ions for providing a first conductivity type into said silicon carbide substrate by using ion beams (J 1) passing through said first opening in said mask layer and through said coating film.

2. The method for manufacturing a silicon carbide semiconductor device according to claim 1, wherein
said step of implanting first impurity ions includes the step of heating said silicon carbide substrate

3. The method for manufacturing a silicon carbide semiconductor device according to claim 1 or 2, wherein
said step of implanting first impurity ions is performed under such a condition that a concentration profile (PF) of said first impurity ions in a direction of thickness is flat at said surface of said silicon carbide substrate.

4. The method for manufacturing a silicon carbide semiconductor device according to any one of claims 1 to 3, further comprising the step of forming on said coating film, a first blocking film (61a to 61c) made of a material higher in capability of blocking said ion beams than said first material, after said step of forming a coating film and before said step of implanting first impurity ions.

5. The method for manufacturing a silicon carbide semiconductor device according to claim 4, wherein
said step of forming a first blocking film (61a) is performed after the step of forming a first opening.

6. The method for manufacturing a silicon carbide semiconductor device according to claim 4, wherein
said step of forming a first blocking film (61 b) is performed before said step of forming a mask layer, and
the method further comprises the step of forming an etching stop layer (70) made of a material different from said second material, after said step of forming a first blocking film and before said step of forming a mask layer.

7. The method for manufacturing a silicon carbide semiconductor device according to any one of claims 1 to 6, wherein
in said step of forming a first opening, said first opening having a first bottom surface and a first sidewall (S1) is formed in said mask layer, and
the method further comprises the steps of:
forming a mask portion (30) having said mask layer and a spacer layer (32) by forming the spacer layer on said first bottom surface and said first sidewall after said step of implanting first impurity ions;
forming a second opening having a second bottom surface and a second sidewall (S2) in said mask portion, by removing said spacer layer on said first bottom surface and allowing said spacer layer on said first sidewall to remain by anisotropically etching said spacer layer in said first opening; and
implanting second impurity ions for providing a second conductivity type different from said first conductivity type into said silicon carbide substrate by using ion beams (J2) passing through said second opening.

8. The method for manufacturing a silicon carbide semiconductor device according to claim 7, further comprising the step of forming a second blocking film (62) on the second bottom surface of said second opening after said step of forming a second opening and before said step of implanting second impurity ions.

9. The method for manufacturing a silicon carbide semiconductor device according to any one of claims 1 to 8, wherein
said second material is silicon oxide.

10. The method for manufacturing a silicon carbide semiconductor device according to any one of claims 1 to 9, wherein
said first material is any of titanium, polysilicon, and silicon nitride.
